# EUROPEAN PATENT APPLICATION

(11) **EP 1 594 354 A1**
(43) Date of publication of application: **09.11.2005**
(21) Application number: 03777271.2
(22) Date of filing: 04.12.2003
(51) Int. Cl.: H05K 13/04, H05K 7/00, H02G 11/00

(54) **WIRING AND PIPING APPARATUS OF PART MOUNTING MACHINE**

(30) Priority: 18.12.2002 JP 2002366775
(71) Applicant: Matsushita Electronics Corporation, Kadoma-shi, Osaka 571-8501 (JP)
(72) Inventor: YOKOYAMA, Dai, Moriguchi-shi, Osaka 570-0005 (JP); MATSUOKA, Satoshi, Hirakata-shi, Osaka 573-1146 (JP); KOYAMA, Toshiyuki, Hirakata-shi, Osaka 573-0027 (JP)
(74) Representative: Haley, Stephen
(86) International application number: PCT/JP2003/015569
(87) International publication number: WO 2004/056166

(57) **Abstract**

A guide belt (6) is stretched over a drive pulley (4) that rotates integrally with a head (1) and a driven pulley (5) situated at one side of the drive pulley (4). One end (9a) of the cable (6) is fixedly attached to a part of the guide belt (6) that is always in contact with the drive pulley (4) when the head (1) rotates, while the cable (9) is extended along the guide belt (6). The cable is bent back in U shape at its midpoint and the cable on the other end side therefrom is extended along a guide member (8) placed substantially in parallel with the guide belt (6) between the drive pulley (4) and the driven pulley (5). The other end (9b) of the cable (9) is fixedly attached to the guide member (8).

## Description

### TECHNICAL FIELD

The present invention relates to a cable/tube installation system for use with component mounting apparatuses for connecting cables and tubes to operating heads that rotate in both rotational directions around and/or move along their axis in both directions at high speed, out of various operating heads of such component mounting apparatuses.

### BACKGROUND ART

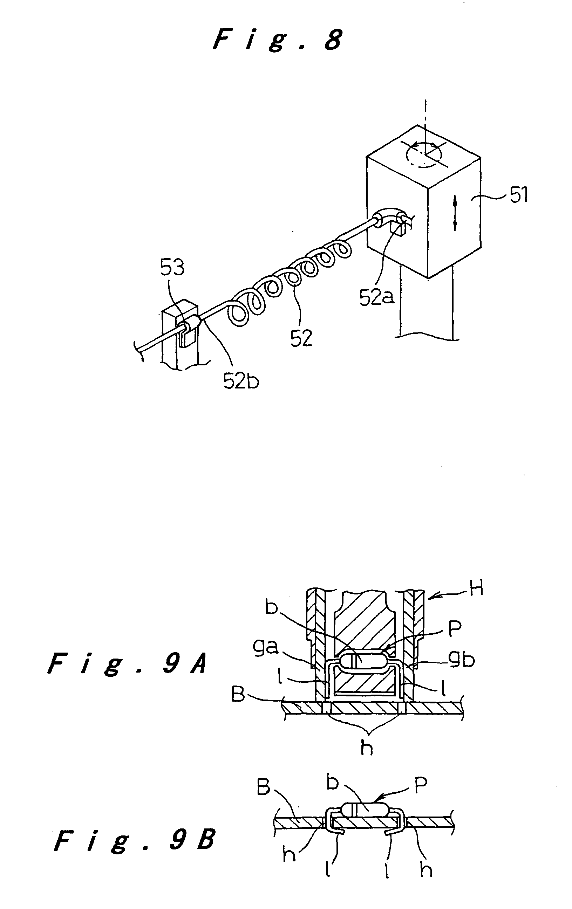

In a component mounting apparatus such as a component inserter, as shown in Fig. 9A, an insertion head H receives a component P to be inserted that has leads 1 extending from the axial ends of the component body b and bends the leads 1 in L-shaped angle. The insertion head H then moves to a predetermined position and rotates around its axis such that the tips of the leads 1 are positioned opposite insertion holes h that are formed in a circuit board B in accordance with the mounting position and orientation of the component P to be inserted, and presses down the component body b so that the leads 1 are inserted into the insertion holes h. The tips of the leads 1 protruding from the lower side of the circuit board B are bent as shown in Fig. 9B by a bending head (not shown) that is also known as "anvil" so that the inserted component P is clinched to the board B. The component is then dipped in solder to connect the bent portions of the leads 1 and electrodes on the underside of the board B, whereby the mounting of the inserted component P is completed.

The insertion head H that carries out these mounting operations usually needs to rotate in the range of 0 to 270 degrees so as to orient the component P in accordance with the predetermined mounting direction, in which polarities on the circuit board B must also be taken into consideration. In addition, the insertion head H usually includes various sensors, encoders, and driving means for the system of adjusting the distance between insertion guides ga and gb in accordance with the size of the component P to be inserted. Therefore, cables and tubes extending from the stationary side of the apparatus are connected to the rotatable insertion head H. The bending head is usually rotated in the range of 0 to 90 degrees and moved up and down so as to be bend the leads 1 in predetermined directions. The bending head that rotates, in both rotational directions, around and moves along its axis also need to be connected to the cables and tubes from the stationary side. In conventional component mounting apparatuses, coiled cords are generally used for the insertion head H or bending head.

Generally, the insertion head H and bending head are operated to rotate and move up and down at a very high speed to achieve high-speed component mounting. In order to make the cycle time of one mounting operation 0.2 to 0.3 sec, for example, the heads must be rotated in one direction at the speed of 50 to 100 msec. The cables and tubes of such high-speed rotatable head in both rotational directions are often deformed irregularly and repeatedly at high speed and swung around. Large and repeated stress applied to fixed parts of the cables and tubes leads to their much shortened life.

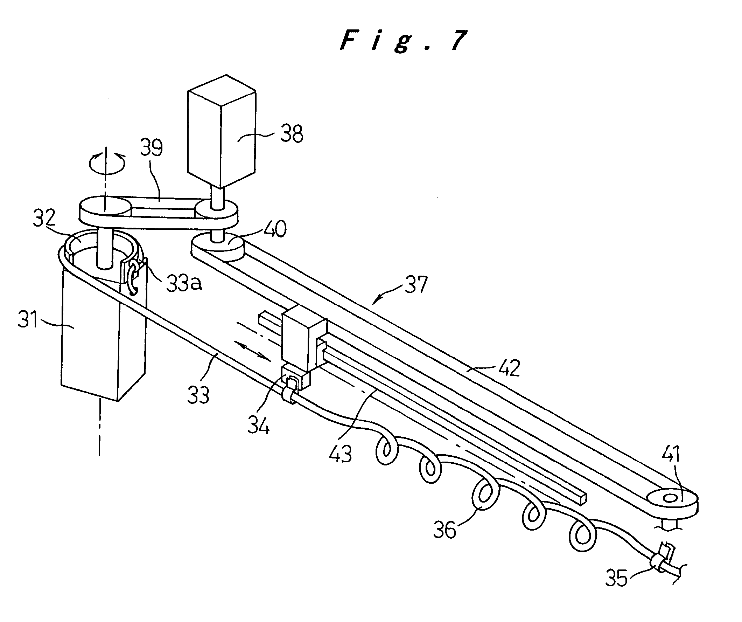

As shown in Fig. 7, the conventional cable installation system is provided with an arc shaped guide 32 concentric with the insertion head 31 and a relay point 34 of the cable 33 distanced from the insertion head 31. The cable 33 is fixed to the arc shaped guide 32 at one end and wound around the guide 32, and extended to and fixed at the relay point 34. The cable consists of the coiled cord 36 between the relay point 34 and a fixed point 35. An interlocking mechanism 37 is provided for causing the relay point 34 to move in synchronization with the rotation of the insertion head 31. So that rotary motion of a cable 33 is converted to linear motion and absorbed by simply stretch and retract of a coiled cord 36. The system thus prevents the cable 33 from being swung around to hit surrounding constituent units or from being sharply bent, to solve the problem of the short life of the cable 33 (refer to Japanese Patent Laid-open Publication No. 9-321488).

In Fig. 7, the reference numeral 38 denotes rotating means of the insertion head 31, and 39 denotes interlocking means for operably connecting the rotating means 38 to the insertion head 31. The interlocking mechanism 37 for the relay point 32 is made up of a drive pulley 40 directly mounted on the rotating means 38, a driven pulley 41 arranged to a side of the drive pulley, a guide belt 42 wound around the two pulleys, and a guide rail 43 that supports the relay point 34, which is fixed to the guide belt 42, such as to be freely movable.

For a bending head, which not only rotates in both rotational directions but also moves up and down along the axis, a coiled cord 52 is connected at one end 52a to the bending head 51 and at the other end 52b to a fixed point 53, as shown in Fig. 8. This is because the rotation angle of the head ranges from 0 to 90 degrees, which is much smaller than that of the insertion head 31.

In the installation system for use with the insertion head 31 shown in Fig. 7, however, the cable 33 still has a short life because, when the rotation speed of the insertion head 31 is increased for higher-speed mounting, the coiled cord 36 is subjected to repeated and rapid stretch and retract, and the coiled cord 36 swings around to collide against surrounding objects or to undergo excessive stress at the fixed parts. Also, the system requires a complex mechanism consisting of many constituent parts. This leads to increased cost.

In the installation system for use with the bending head 51 shown in Fig. 8, too, while the rotation angle of the bending head 51 is relatively small as compared with the insertion head 31, the coiled cord 52 undergoes rapid stretch and retract and swings around when the rotation speed is increased. Heavy collision between the coiled cord 52 and other objects and excessive stress at the fixed parts lead to a shortened life of the cable.

Based on the foregoing, it is an object of the present invention to overcome the conventional problems, and to provide a simple and low-cost cable/tube installation system for use with a component mounting apparatus, which ensures a long life of cables or tubes connected to operating heads that rotate in both rotational directions and/or move along its axis up and down at high speed.

### DISCLOSURE OF THE INVENTION

The cable/tube installation system for use with a component mounting apparatus according to a first aspect of the present invention is a cable installation system for use with an operating head that rotates around its axis in a component mounting apparatus, wherein a cable is fixedly attached at one end thereof to the operating head and at the other end to a stationary part of the apparatus, the system comprising a drive pulley that rotates integrally with the head, a driven pulley situated at one side of the drive pulley, a guide belt stretched over the drive pulley and the driven pulley, and a guide member placed substantially in parallel with the guide belt between the drive pulley and the driven pulley, the one end of the cable being fixedly attached to a part of the guide belt that is always in contact with the drive pulley when the head rotates, the other end of the cable being fixedly attached to the guide member, the cable being bent in U shape at the midpoint, and extended along the guide belt on one side and along the guide member on the other side.

With this system, the cable is bent in U shape at the midpoint and one end of the cable moves with the guide belt that rotates with the head, while the other end of the cable runs along, and is received by the guide member such that the length of the part of the cable held by the guide member changes in accordance with the rotation of the head. There is no heavy collision between the cable and other parts, nor any excessive stress at fixed parts of the cable, even though the head rotates in both directions at high speed, and so the life of the cable is made longer. The system is thus constructed simple and at low cost, as it only consists of the drive pulley, the driven pulley, the guide belt, and the guide member.

A portion of the cable at the one end which is wound around the drive pulley when the head rotates is fixed to the guide belt so as to make sure that the cable surely runs along the guide belt even under the influence of the centrifugal force during the high-speed rotation of the head and that the above described effects are stably achieved.

The cable/tube installation system for use with a component mounting apparatus according to a second aspect of the present invention is a cable installation system for use with an operating head that rotates around its axis in a component mounting apparatus, wherein a cable is fixedly attached at one end thereof to the operating head and at the other end to a stationary part of the apparatus, the system comprising a circular pulley coaxial and rotatable with the head, and a guide member opposite the outer periphery of the pulley with a space, wherein the cable is bent in U shape with the one end of the cable being fixed to the pulley and the other end to the guide member, the one end side being wound around the pulley, while the other end side is extended along the guide member.

With this system, the cable is bent in U shape at the midpoint and when the head rotates, the length of the part runs along, and is received by, the guide member changes in accordance with the angle at which the cable is wound around the pulley. There is no heavy collision between the cable and other parts, nor any excessive stress at fixed parts of the cable, even though the head rotates in both directions at high speed, and so the life of the cable is made longer. The system is thus constructed simpler and at lower cost than the system described in the first aspect, as it only consists of the pulley and the guide member.

The guide member has an arc shape concentric with the pulley so that the U-shaped bent-back portion of the cable always has the same radius of curvature as it moves. This ensures that the cable moves as designed when the head rotates at high speed and that the above discussed effects are achieved.

The cable/tube installation system for use with a component mounting apparatus according to a third aspect of the present invention is a cable installation system for use with an operating head that rotates around its axis in a component mounting apparatus, wherein a cable is fixedly attached at one end thereof to the operating head and at the other end to a stationary part of the apparatus, the system comprising a movable guide member fixedly mounted to the head perpendicularly to the axis of the head, and a stationary guide member mounted in parallel with the movable guide member. The cable is laid in an arc shape and bent back in U shape with the center axis of the arc maintained the same, wherein the one end of the cable is fixedly attached to the movable guide member and the other end of the cable is fixedly attached to the stationary guide member, with the center axis of the arc shape of the cable coincides with the axis of the head.

With this system, the cable is bent in U shape and when the movable guide member rotates with the rotation of the head, the length of the part held along the movable guide member in an arc shape changes inversely with the length of the part held along the stationary guide member in an arc shape via the U-shaped bent-back portion. There is no heavy collision between the cable and other parts, nor any excessive stress at fixed parts of the cable, even though the head rotates in both directions at high speed, and so the life of the cable is made longer. The system is thus constructed simpler and at lower cost than the system described in the first aspect, as it only consists of the movable guide member and the stationary guide member.

A plurality of the cables, each bent back in U shape of the same diameter, may be arranged in a circumferential direction between the movable guide member and the stationary guide member, so that a large number of cables are divided into a plurality of groups of cables and that each cable arranged in an arc shape has a smaller radial width. This reduces the outer diameter of the arc shape of the cables, and enables the entire system to be configured compactly.

The above-described system is preferably used for a head that rotates around and moves along the axis, because a change in the distance between the movable guide member and the stationary guide member is smoothly absorbed by a change in the radius of curvature of the U-shaped bent-back portion of the cable, and the above-discussed effects are achieved.

In the cable/tube installation system for use with a component mounting apparatus described above, the cable is preferably composed of a flat cable in which a plurality of cables are arranged side by side.

The cable may also be, partly or entirely, replaced by a tube composed of a flexible tube member.

### BRIEF DESCRIPTION OF THE DRAWINGS

Fig. 1 is a perspective view of a first embodiment of the cable/tube installation system for a component mounting apparatus according to the invention;
Figs. 2A to 2D are diagrams given in explanation of the operation of the system of the same embodiment;
Fig. 3 is a perspective view of a second embodiment of the cable/tube installation system for a component mounting apparatus according to the invention;
Figs. 4A and 4B are diagrams given in explanation of the operation of the system of the same embodiment;
Fig. 5 is a perspective view of a third embodiment of the cable/tube installation system for a component mounting apparatus according to the invention;
Figs. 6A and 6B are plan views of a flat cable used in the same embodiment, Fig. 6A being a developed flat view and Fig. 6B being a flat view of the cable bent back;
Fig. 7 is a perspective view of a conventional cable/tube installation system for a component mounting apparatus;
Fig. 8 is a perspective view of another conventional cable/tube installation system for a component mounting apparatus; and
Figs. 9A and 9B are longitudinal cross sectional views showing an insertion step in a component mounting apparatus.

### BEST MODE FOR CARRYING OUT THE INVENTION

### (First Embodiment)

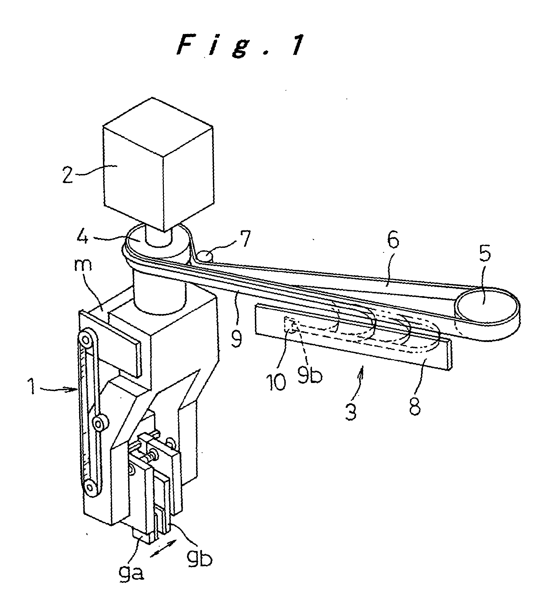

A first embodiment of a cable/tube installation system for a component mounting apparatus of the invention will be hereinafter described with reference to Figs. 1, 2A-2D, 9A, and 9B.

The system of this embodiment is used for connecting cables to insertion heads of component inserters. As shown in Figs. 9A and 9B, the insertion head 1 holds a component P with its leads 1 bent at right angles such that the leads 1 will be inserted into insertion holes h formed in the circuit board B. The head 1 includes various sensors for detecting the conditions of the component P to be inserted and an encoder for sensing the rotation angle of the insertion head, as well as a drive motor m, as shown in Fig. 1, for moving insertion guides ga and gb in accordance with the pitch distance between the insertion holes h. In addition, the insertion head 1 is designed to be rotatable around its axis with the use of rotating means 2 so that the insertion head 1 will be oriented at 0°, 90°, 180°, or 270° to insert the component P at a specified angle relative to the board B. The insertion head 1 thus requires a cable installation system 3 that connects cables between the rotatable insertion head 1 and the stationary side for exchange of signals with the various sensors and the encoder on the insertion head 1 and for supplying power to the drive motor m.

With reference to Fig. 1, the cable installation system 3 includes a drive pulley 4 mounted integrally with, and concentrically with the rotation axis of, the insertion head 1, and a driven pulley 5 spaced from the drive pulley 4 a certain distance on one side, with a guide belt 6 being wound around the drive and driven pulleys 4 and 5. A guide roller 7 is placed in contact with the belt 6 such that the belt is wound around the drive pulley 4 at least 270°. A guide member 8 is located substantially in parallel with the guide belt 6 between the drive and driven pulleys 4 and 5 with a certain distance.

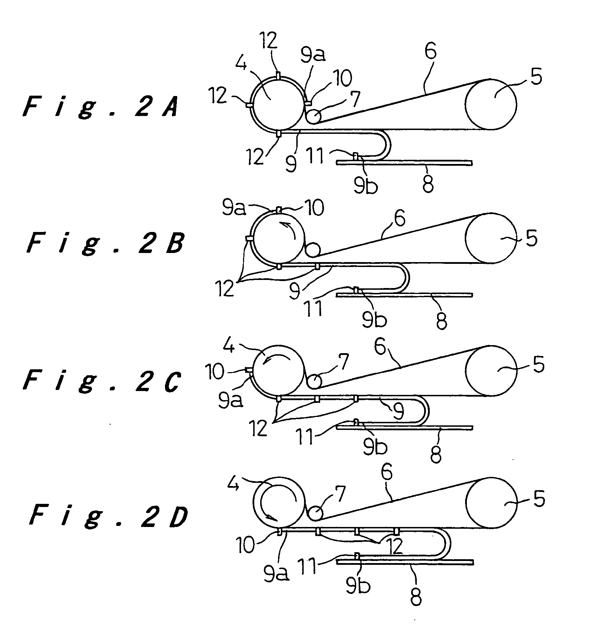

The reference numeral 9 denotes a strip of flat cable in which a plurality of signal lines and power lines are arranged side by side. One end 9a on the insertion head 1 side is fixed to the guide belt 6 with a fixing tool 10. The one end 9a of this cable 9 is positioned such that it is maintained in contact with the drive pulley 4 irrespective of the rotational position of the insertion head 1. The cable 9 that is fixed at one end runs along the guide belt 6 and is bent back at the midpoint in U shape. From the bent back portion it further extends along the guide member 8, and the other end 9b of the cable 9 is fixed to the guide member 8 with a fixing tool 11. As shown in Figs. 2A to 2D, the cable 9 is fixed to the guide belt 6 with fixing tools 12 near one end in the portion that is wound around the drive pulley 4 when the insertion head 1 rotates.

When the rotating means 2 rotates the insertion head 1 to a predetermined rotational position, the drive pulley 4 rotates integrally with the head 1 and moves the guide belt 6. As the one end 9a of the cable 9 that is fixed to a predetermined position on the periphery of the drive pulley 4 moves with the movement of the guide belt 6, the other end extended from the U-shaped midpoint of the cable 9 runs along, and is received by, the guide member 8, as shown in sequence from Fig. 2A to Fig. 2D. Thus the length of the portion of the cable 9 that runs along the guide member 8 will be changed as the one end of the cable 9 moves with the rotation of the insertion head 1.

With this system, the cable 9 does not collide against surrounding objects and its fixed ends 9a and 9b do not receive any excessive stress even if the insertion head is rotated at a high speed of, e.g. 30 to 60 msec, in both directions to achieve 0.1-0.2 sec cycle time of one mounting operation. Thus the flat cable 9 will have longer life. The system only requires the drive pulley 4, the driven pulley 5, the guide belt 6, and the guide member 8. The system does not include any complex synchronizing or interlocking mechanisms so that the system is configured simply and at low cost.

The fixing tools 12, which are provided to fix one end of the flat cable 9 to the guide belt 6 at certain intervals in the portion that is wound around the drive pulley 4 when the insertion head 1 rotates, prevent the wound around part of the cable 9 from lifting up from the drive pulley 4 during the high-speed rotation of the head 1 due to centrifugal force. These fixing tools 12 ensure that the flat cable 9 always runs along the guide belt 6, so that the above-described effects are achieved stably and securely.

### (Second Embodiment)

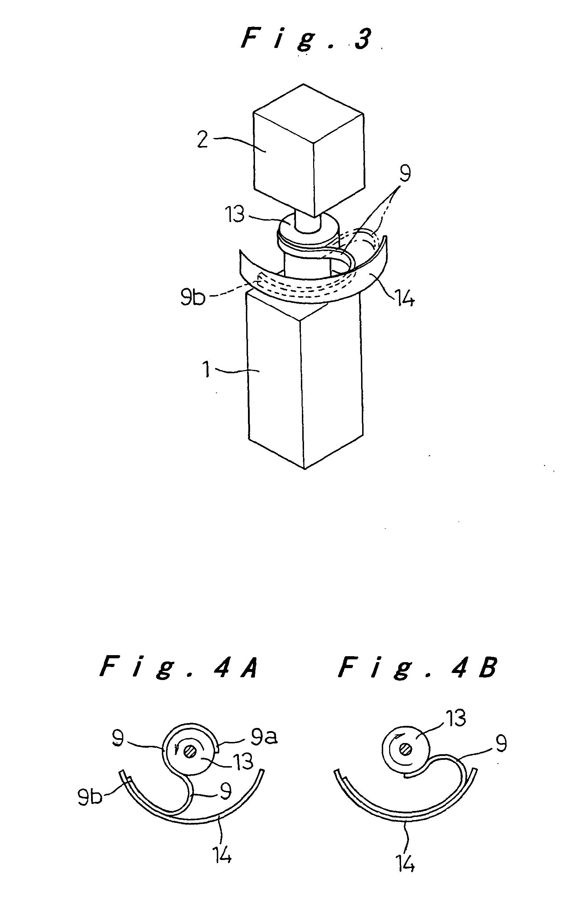

A second embodiment of a cable/tube installation system for a component mounting apparatus according to the invention will be described hereinafter with reference to Figs. 3, 4A, and 4B. Incidentally, components of the present embodiment that are similar to those of the previously discussed embodiment will be given the same reference number and only the differences will be described.

The present embodiment relates to a cable installation system 3 also for use with an insertion head 1 of a component inserter. The system includes a circular pulley 13 that is concentric with the axis of the insertion head 1 and rotates integrally with the head, and a guide member 14 that is located opposite the outer periphery of the pulley 13 with a certain distance. One end 9a of the cable 9 is fixed to the pulley 13. The cable 9 is wound around the pulley 13 from this fixed end, then bent back in U shape and extended along the guide member 14. The other end 9b of the cable 9 is fixed to the guide member 14. The guide member 14 has an arc shape that is concentric with the pulley 13.

With the change in the winding angle of the cable 9 around the pulley 13 when the insertion head 1 rotates, the length of the other side from the U-shaped midpoint of the cable, which runs along and is received by the guide member 14 increases and decreases. Even when the insertion head 1 rotates in both directions at high speed, no heavy collision occurs between the cable 9 and surrounding objects and no excessive stress is applied to both fixed ends 9a and 9b, and therefore the flat cable 9 will have longer life. Further, because the guide member 14 has an arc shape that is concentric with the pulley 13, the curvature of the U-shaped bent-back part of the cable is always maintained the same, ensuring that the cable 9 stably moves even in high-speed operation of the insertion head 1 and that the above-described effects are achieved.

In addition, the present embodiment has an even simpler and lower-cost structure than the first embodiment, as the cable installation system 3 of the embodiment includes only the pulley 13 and guide member 14.

### (Third Embodiment)

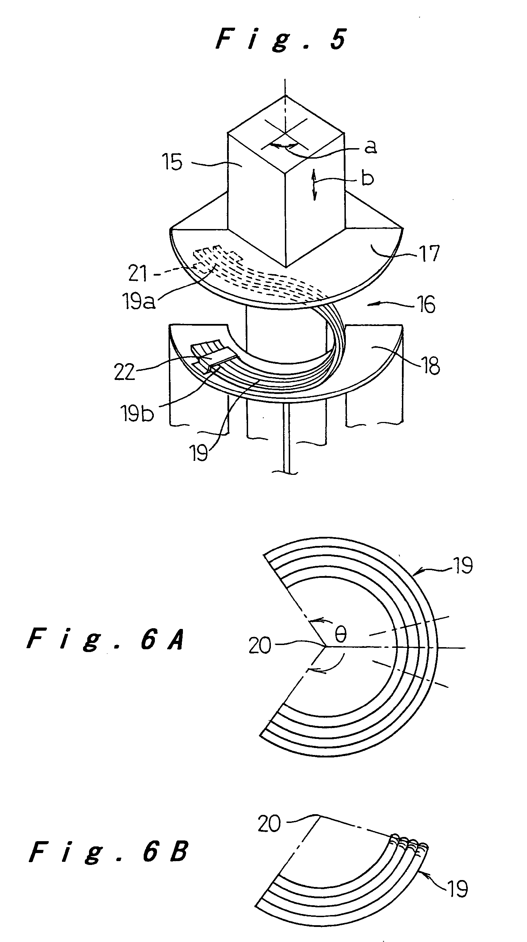

A third embodiment of a cable/tube installation system for a component mounting apparatus according to the invention will be described hereinafter with reference to Figs. 5, 6A, and 6B.

The present embodiment relates to a cable installation system 16 for use with a bending head 15, also referred to as "anvil," of a component inserter. The bending head 15 rotates in both directions in the angle range of 0 to 90 degrees as indicated by the arrow "a" in Fig. 5, and moves up and down several tens mm along its axis as indicated by the arrow "b."

As shown in Fig. 5, the cable installation system 16 for such a bending head 15 includes a movable guide member 17 that is fixed perpendicularly to the axis of the bending head 15, and a stationary guide member 18 placed in parallel with the movable guide member 17. A cable 19 that consists of a plurality of signal lines and power lines arranged side by side is laid in an arc shape as shown in Fig. 6A and bent back in U shape such that the center axis 20 of that arc is maintained the same as shown in Fig. 6B. One end 19a of the cable 19 is fixed to the movable guide member 17 with a fixing tool 21, while the other end 19b is fixed to the stationary guide member 18 with a fixing tool 22 such that the center axis 20 of the flat cable 19 is made to coincide with the axis of the bending head 15.

When the cable 19 is placed flat as shown in Fig. 6A, the maximum angle θ of the arc extends approximately 360 degrees. In this case, when bent in U shape as shown in Fig. 6B, the flat cable 19 extends approximately 180 degrees, and the bending head 15 rotates approximately 360 degrees.

With this system configured described above, when the movable guide member 17 rotates with the rotation of the bending head 15, the length of part of the cable 19 on one side of the U-shaped bent-back part, which is received by the movable guide member 17 in an arc shape, changes inversely with the length of part of the cable 19 on the other side which is received by the stationary guide member 18 in an arc shape. When the bending head 15 moves along its axis and changes the distance between the movable guide member 17 and the stationary guide member 18, this change in the distance is smoothly absorbed by a change in the curvature of the U-shaped bent-back part of the cable 19. Therefore, no heavy collision occurs between the cable 19 and surrounding objects and no excessive stress is applied to fixed parts of the cable even though the bending head 15 rotates in both directions and moves up and down along its axis at high speed. The cable 19 will thus have longer life. In addition, this embodiment has an even simpler and lower-cost structure than the first embodiment, as the system includes only the movable and stationary guide members 17 and 18.

While only a single cable 19 has been shown placed between the movable and stationary guide members 17 and 18, a plurality of cables 19 may be arranged in the circumferential direction between the movable and stationary guide members 17 and 18. In an application where signal lines and power lines are given in large numbers, the lines may be divided into a plurality of groups and the number of cables included in a single cable will be decreased. Each cable 19 will then have a smaller radial width than in the case where all the lines are bundled in one thick cable. The reduction in the outer diameter of the cable 19 will allow the entire system to be configured more compactly.

While flat cables have been shown for the cables 9 and 19 in the above-described embodiments, the cable may have any other cross-sectional shape. Flat cables are preferable in respect that less bending stress is applied to the part wound around the pulley or bent in U shape, and this will improve durable life of the cable.

While only cables 9 and 19 have been shown in the above-described embodiments, the present invention is not limited to the cases where cables are installed. The present invention will be applied to cases where the cables are, partly or entirely, replaced with tubes composed of a flexible tube material, with the same effects.

Further, while component inserters have been shown as one example of component mounting apparatuses in the above described embodiments, the present invention is applicable also to heads for use in other machines such as surface mounters or adhesive or sealant applicators with the same effects.

### INDUSTRIAL APPLICABILITY

As discussed above, in the first aspect of the invention, one end of the cable moves with the guide belt that rotates with the rotation of the head. The cable is bent back in U shape at the midpoint and the other end side runs along, and is received by, the guide member. As the head rotates, the length of part of the cable received by the guide member changes. The cable has longer life because no collision of the cables occurs and no excessive stress is applied to fixed parts even in high-speed reciprocal rotation of the head. The system is configured simply and at low cost as it includes only a drive pulley, a driven pulley, a guide belt, and a guide member.

In the second aspect of the invention, as the head rotates and the winding angle of the cable around the pulley changes, the length of part of the cable running along and received by the guide member changes on the other end side of the U-shaped bent-back midpoint of the cable. The cable has longer life because no collision of the cable occurs and no excessive stress is applied to fixed parts even in high-speed reciprocal rotation of the head. The system is configured even more simply and at lower cost as it includes only a pulley and a guide member.

In the third aspect of the invention, the cable is extended along the movable guide member at one end and along the stationary guide member at the other end in an arc shape. As the movable guide member rotates with the rotation of the head, the lengths of both end sides of the U-shaped bent-back midpoint of the cable change inversely with each other. The cable has longer life because no collision of the cable occurs and no excessive stress is applied to fixed parts even in high-speed reciprocal rotation of the head. The system is configured even more simply and at lower cost as it includes only movable and stationary guide members.

## Claims

1. A cable/tube installation system for use with a component mounting apparatus, the system being a cable installation system (3) for use with an operating head (1) that rotates around its axis in a component mounting apparatus, wherein a cable (9) is fixedly attached at one end (9a) thereof to the operating head (1) and at the other end (9b) to a stationary part of the apparatus,
the system comprising: a drive pulley (4) that rotates integrally with the head (1); a driven pulley (5) situated at one side of the drive pulley (4); a guide belt (6) stretched over the drive pulley (4) and the driven pulley (5); and a guide member (8) placed substantially in parallel with the guide belt (6) between the drive pulley (4) and the driven pulley (5), the one end (9a) of the cable (9) being fixedly attached to a part of the guide belt (6) that is always in contact with the drive pulley (4) when the head (1) rotates, the other end (9b) of the cable (9) being fixedly attached to the guide member (8), the cable (9) being bent in U shape at the midpoint, and extended along the guide belt (6) on one side and along the guide member (8) on the other side.

2. The cable/tube installation system for use with a component mounting apparatus according to claim 1, wherein a portion of the cable (9) at the one end (9a) which is wound around the drive pulley (4) when the head (1) rotates is fixed to the guide belt (6).

3. A cable/tube installation system for use with a component mounting apparatus, the system being a cable installation system (3) for use with an operating head (1) that rotates around its axis in a component mounting apparatus, wherein a cable (9) is fixedly attached at one end (9a) thereof to the operating head (1) and at the other end (9b) to a stationary part of the apparatus,
the system comprising: a circular pulley (13) coaxial and rotatable with the head (1); and a guide member (14) opposite the outer periphery of the pulley (13) with a space, wherein the cable (9) is bent in U shape with the one end (9a) of the cable (9) being fixed to the pulley (13) and the other end (9b) to the guide member (14), the one end (9a) side being wound around the pulley (13), while the other end (9b) side is extended along the guide member (14).

4. The cable/tube installation system for use with a component mounting apparatus according to claim 3, wherein the guide member (14) has an arc shape concentric with the pulley (13).

5. A cable/tube installation system for use with a component mounting apparatus, the system being a cable installation system (3) for use with an operating head (15) that rotates around its axis in a component mounting apparatus, wherein a cable (19) is fixedly attached at one end (19a) thereof to the operating head (15) and at the other end (19b) to a stationary part of the apparatus,
the system comprising: a movable guide member (17) fixedly mounted to the head (15) perpendicularly to the axis of the head (15); and a stationary guide member (18) mounted in parallel with the movable guide member (17), wherein the cable (19) is laid in an arc shape and bent back in U shape with the center axis (20) of the arc maintained the same, the one end (19a) of the cable (19) being fixedly attached to the movable guide member (17) and the other end (19b) of the cable (19) being fixedly attached to the stationary guide member (18), with the center axis (20) of the arc shape of the cable (19) being coincided with the axis of the head (15).

6. The cable/tube installation system for use with a component mounting apparatus according to claim 5, wherein a plurality of the cables (19), each bent back in U shape of the same diameter, are arranged in a circumferential direction between the movable guide member (17) and the stationary guide member (18).

7. The cable/tube installation system for use with a component mounting apparatus according to claim 5 or 6, wherein the head (15) rotates around and moves along the axis.

8. The cable/tube installation system for use with a component mounting apparatus according to any of claims 1, 3, and 5, wherein the cable (9, 19) is composed of a flat cable in which a plurality of cables are arranged side by side.

9. The cable/tube installation system for use with a component mounting apparatus according to any of claims 1, 3, and 5, wherein the cable (9, 19) is partly or entirely replaced by a tube composed of a flexible tube member.
